# EUROPÄISCHE PATENTSCHRIFT

(11) **EP 3 980 302 B1**
(45) Veröffentlichungstag und Bekanntmachung des Hinweises auf die Patenterteilung: **10.01.2024**
(21) Anmeldenummer: 20732146.4
(22) Anmeldetag: 04.06.2020
(51) Int. Cl.: B60T 8/76, B60T 8/171, G01P 1/02, G01P 3/44, G01P 3/487

(54) **RADDREHZAHLSENSOR FÜR EIN NUTZFAHRZEUG**
WHEEL SPEED SENSOR FOR A COMMERCIAL VEHICLE
CAPTEUR DE VITESSE DE ROUE POUR VÉHICULE UTILITAIRE

(30) Priorität: 06.06.2019 DE 102019115397
(43) Veröffentlichungstag der Anmeldung: 13.04.2022
(73) Patentinhaber: KNORR-BREMSE Systeme für Nutzfahrzeuge GmbH, 80809 München (DE)
(72) Erfinder: KLUFTINGER, Andre, 63924 Kleinheubach (DE); WINDISCH, Andreas, 82008 Unterhaching (DE); LECHNER, Klaus, 91362 Pretzfeld (DE); JAWARIKAR, Pravin, 444303 Distr. Buldhana (IN); HAUFF, Michael, 81379 München (DE); ROHSE, Tobias, 71701 Schwieberdingen (DE)
(86) Internationale Anmeldenummer: PCT/EP2020/065452
(87) Internationale Veröffentlichungsnummer: WO 2020/245254

(56) Entgegenhaltungen:
- WO-A1-2017/178215
- DE-U1-202013 011 157
- KR-A- 20100 062 613
- KR-B1- 100 931 126

## Beschreibung

Die Erfindung betrifft einen Raddrehzahlsensor für ein Nutzfahrzeug, insbesondere einen Raddrehzahlsensor für ein Nutzfahrzeug, der im Bereich einer Bremse eines Rads an einem Fahrwerk des Nutzfahrzeugs angeordnet ist.

Eine Erfassung von Raddrehzahlen von einzelnen Rädern von Fahrzeugen ist heutzutage erforderlich, um eine Funktion von Assistenzsystemen, beispielsweise ABS, ASR, ESP, zu ermöglichen. Dabei ist eine genaue Erfassung erforderlich, um in Grenzsituationen entsprechende Algorithmen anzusteuern. Um die Raddrehzahlen genau zu erfassen, sind Raddrehzahlsensoren bekannt, die im Bereich eines Rads des Fahrzeugs angeordnet sind, um die Drehzahl möglichst unmittelbar, ohne Abweichungen durch eine mechanische Übertragung, zu erfassen.

Im PKW-Bereich werden vermehrt aktive Raddrehzahlsensoren eingesetzt, die bereits im Raddrehzahlsensor Signale, die beispielsweise eine drehzahlunabhängige konstante Amplitude aufweisen, erzeugen. Somit wird bereits im Raddrehzahlsensor ein Datenprotokoll erzeugt, das, beispielsweise über ein Bus-System übertragen, in einem Steuergerät ausgewertet werden kann. Außerdem besteht die Möglichkeit, Diagnosefunktionen zu implementieren. Jedoch war im Nutzfahrzeugbereich ein Einsatz der aktiven Raddrehzahlsensoren bislang nicht möglich, da hier im Bereich des Rades eine thermische Belastung des Sensors größer als im PKW-Bereich ist und insbesondere Chips von Hall-Gebern der thermischen Belastung nicht standhalten.

Unter Anderem aus diesem Grund werden AMR-Sensoren, die einen Chip mit einem "Anisotropen MagnetoResistiven"-Effekt aufweisen, für die aktiven Raddrehzahlsensoren eingesetzt. Die AMR-Sensoren haben jedoch gegenüber den Hall-Gebern den Nachteil, dass sie nur eine bestimmte Erfassungsrichtung haben, in der eine Bewegung eines Impulsgebers erfasst werden kann, wohingegen konventionelle Hall-Geber auf keine bestimmte Erfassungsrichtung beschränkt sind, sondern eine Bewegung in jeglicher Richtung erfassen können. Daher ist es bei der Verwendung von AMR-Sensoren notwendig, die Raddrehzahlsensoren in einer vorbestimmten Orientierung in das Fahrzeug zu montieren.

Aufgrund von Beschränkungen des Bauraums ist es jedoch erforderlich, im Falle von Raddrehzahlsensoren mit einer langgestreckten Form, einen Kabelabgang nicht axial an einem Ende des Raddrehzahlsensors vorzusehen, sondern einen radialen Kabelabgang vorzusehen. Dabei besteht jedoch das Problem, dass die Kabelabgänge der Raddrehzahlsensoren in Abhängigkeit des vorhandenen Bauraums bezüglich einer Orientierung des AMR-Sensors in unterschiedlichen Winkelpositionen vorgesehen sein müssen. Dies verteuert die Fertigung, da, beispielsweise im Falle von Raddrehzahlsensoren, deren Gehäuse in einem Gießverfahren hergestellt wird, unterschiedliche Werkzeuge für die Raddrehzahlsensoren mit den Kabelabgängen in unterschiedlichen Winkelpositionen erforderlich sind.

Die Dokumente KR 100931126 B1 und KR 20100062613 A offenbaren jeweils einen Raddrehzahlsensor mit den Merkmalen gemäß dem Oberbegriff des Anspruchs 1.

In Dokument WO 2017/178215 A1 und in Dokument DE 20 2013 011 157 U1 ist jeweils ein aktiver Raddrehzahlsensor mit einem AMR-Sensor offenbart.

Der Erfindung liegt also die Aufgabe zugrunde, den obigen Nachteil zu beseitigen und einen Raddrehzahlsensor bereitzustellen, der auch in einem Bereich mit einer höheren thermischen Belastung in einem eingeschränkten Bauraum eingesetzt werden kann.

Die Aufgabe wird durch einen Raddrehzahlsensor gemäß Anspruch 1 und ein Verfahren gemäß Anspruch 6 gelöst. Vorteilhafte Weiterentwicklungen sind in den abhängigen Ansprüchen enthalten.

Gemäß einem Aspekt der Erfindung weist ein Raddrehzahlsensor für ein Nutzfahrzeug einen aktiven Impulssensor mit einer vorbestimmten Erfassungsrichtung und ein Gehäuse, das ausgebildet ist, den Impulssensor zumindest teilweise zu umschließen, auf. Durch den Impulssensor ist eine Bewegung eines Impulsgebers in der vorbestimmten Erfassungsrichtung erfassbar, und der Raddrehzahlsensor weist eine Achse auf, wobei eine Richtung der Achse so definiert ist, dass sie senkrecht zu der Erfassungsrichtung des Impulssensors ausgerichtet ist. Das Gehäuse weist ein erstes Bauteil und ein zweites Bauteil, von dem das erste Bauteil zumindest teilweise umschließbar ist und mit dem das erste Bauteil zumindest teilweise formschlüssig verbindbar ist, auf. Der Impulssensor ist an dem ersten Bauteil befestigt und der Raddrehzahlsensor weist einen radialen Kabelabgang auf, der radial zu der Achse des Raddrehzahlsensors ausgerichtet ist und der ein Kabel aus dem Raddrehzahlsensor herausführt, wobei der radiale Kabelabgang integral mit dem zweiten Bauteil so ausgebildet ist, dass das Kabel in einer anderen Richtung als in Richtung der Achse des Raddrehzahlsensors herausgeführt wird. Das erste Bauteil weist in der Richtung der Achse einen ersten Bereich auf, der eine andere als eine rotationssymmetrische Kontur an seinem Umfang aufweist, und das zweite Bauteil weist einen zweiten Bereich auf, dessen innere Kontur zumindest teilweise komplementär zu der Kontur am Umfang des ersten Bereichs ausgebildet ist, und die Kontur am Umfang des ersten Bereichs weist jeweils ein Formmerkmal in vorbestimmten Winkelschritten um die Achse des Raddrehzahlsensors auf, so dass das erste Bauteil so ausgebildet ist, dass bei einem Verbinden eine Orientierung des ersten Bauteils zu dem zweiten Bauteil in den vorbestimmten Winkelschritten um die Achse definierbar ist, um einen vorbestimmten Winkel um die Achse zwischen der Erfassungsrichtung des Impulssensors und dem radialen Kabelabgang bereitzustellen.

Der aktive Impulssensor ist ein Sensor, der Impulse erfasst, die durch eine Veränderung eines Magnetfelds in einem Erfassungsbereich des Sensors erzeugt werden. Die Veränderung des Magnetfelds im Bereich des Sensors erfolgt entweder durch Einbringen eines magnetischen Körpers, beispielsweise eines sich drehenden Polrads mit daran angebrachten Permanentmagneten, in den Erfassungsbereich oder durch Veränderung eines stationären Magnetfelds im Bereich des Sensors. Das stationäre Magnetfeld wird durch Einbringen eines ferromagnetischen Körpers in den Erfassungsbereich verändert. Hierbei wird ein Impulsrad, das am Umfang Zähne und Lücken aufweist, im Erfassungsbereich des Sensors bewegt und die Veränderung des Magnetfelds durch die sich durch den Erfassungsbereich bewegenden Zähne und Lücken erfasst. Dabei kann sowohl ein Übergang von einem Zahn zu einer Lücke als auch ein Übergang von einer Lücke zu einem Zahn erfasst werden.

Durch einen solchen Raddrehzahlsensor ist es möglich, variabel, beispielsweise in einem zweites-Bauteil-Gießwerkzeug für das zweite Bauteil, Raddrehzahlsensoren mit unterschiedlichen Winkelzuordnungen zwischen der Erfassungsrichtung des Impulssensors und dem radialen Kabelabgang herzustellen.

Bei einer vorteilhaften Weiterbildung des Raddrehzahlsensors weist der Impulssensor einen AMR-Sensor auf.

Der AMR-Sensor bietet eine hohe Auflösung und eine große Genauigkeit. Darüber hinaus ist er, im Vergleich zu anderen Sensoren gegenüber Öl, Schmutz und Umgebungstemperaturen relativ unempfindlich.

Erfindungsgemäß ist das erste Bauteil als ein Kunststoff-Formteil ausgebildet, und zweite Bauteil ist durch Umgießen des ersten Bauteils mit einem Kunststoff ausgebildet.

Da durch das Umgießen des ersten Bauteils mit dem Kunststoff, der das zweite Bauteil bildet, das Gehäuse des Raddrehzahlsensors gebildet wird, ist ein solcher Raddrehzahlsensor ist kostengünstig herstellbar.

In einer weiteren vorteilhaften Weiterbildung des Raddrehzahlsensors weisen das erste Bauteil und das zweite Bauteil ein gleiches Material auf.

Ein solcher Raddrehzahlsensor weist den Vorteil auf, dass ein Wärmeausdehnungskoeffizient der Materialien des ersten und zweiten Bauteils gleich ist, so dass bei thermischer Belastung ein Auftreten von inneren Spannungen in dem Gehäuse des Raddrehzahlsensors minimiert wird.

Gemäß einer weiteren vorteilhaften Weiterbildung des Raddrehzahlsensors liegen die vorbestimmten Winkelschritte in einem Bereich 80° bis 100°, besonders bevorzugt bei 90°.

Eine Herstellmöglichkeit des Raddrehzahlsensors mit einem solchen Raster bietet für übliche Anwendungsfälle immer eine geeignete Winkelzuordnung zwischen der Erfassungsrichtung des Impulssensors und dem radialen Kabelabgang.

Bei einer weiteren vorteilhaften Weiterbildung des Raddrehzahlsensors liegen die vorbestimmten Winkelschritte in einem Bereich von 40° bis 50°, besonders bevorzugt bei 45°.

Eine Herstellmöglichkeit des Raddrehzahlsensors mit einem solchen Raster bietet für Anwendungsfälle mit besonders eingeschränkten Bauraum eine geeignete Winkelzuordnung zwischen der Erfassungsrichtung des Impulssensors und dem radialen Kabelabgang.

Gemäß einem weiteren Aspekt der Erfindung weist ein Verfahren die folgenden Schritte auf: Bereitstellen einer Vormontagebaugruppe, die das ersten Bauteil, den Impulssensor und das Kabel vormontiert aufweist, in einem zweites-Bauteil-Gießwerkzeug zur Herstellung des zweiten Bauteils einschließlich des radialen Kabelabgangs; Orientieren des ersten Bauteils in dem Gießwerkzeug durch Einbringen von einem der Formmerkmale in ein entsprechendes Gegenformmerkmal des zweites-Bauteil-Gießwerkzeugs so, dass ein gewünschter vorbestimmter Winkel zwischen dem Impulssensor und dem radialen Kabelabgang um die Achse des Raddrehzahlsensors festgelegt wird; Umgießen des ersten Bauteils und des Kabels, so dass das zweite Bauteil mit dem radialen Kabelabgang um das erste Bauteil herum hergestellt wird.

Durch ein solches Verfahren ist es möglich, in einem einzigen Gießwerkzeug für das zweite Bauteil, Raddrehzahlsensoren mit unterschiedlichen Winkelzuordnungen zwischen der Erfassungsrichtung des Impulssensors und dem radialen Kabelabgang variabel herzustellen.

Gemäß einer weiteren vorteilhaften Weiterbildung des Verfahrens enthält es zusätzliche Schritte zur Herstellung der Vormontagebaugruppe: Umgießen von Stromschienen in einem erstes-Bauteil-Gießwerkzeug; Verbinden des Kabels mit den Stromschienen; Verbinden des Impulssensors mit den Stromschienen.

Mit diesen Schritten ist es möglich Funktionsteile des Raddrehzahlsensors in einer Vormontagebaugruppe kostengünstig zu fixieren und zu verbinden, wobei die Vormontagebaugruppe dann zum Schutz der Funktionsteile nochmals kostengünstig umgossen werden kann.

Nachstehend wird die Erfindung anhand eines Ausführungsbeispiels unter Bezugnahme auf die beigefügten Zeichnungen erläutert.

Insbesondere zeigt:
- Fig. 1: eine Explosionsdarstellung einer bevorzugten Ausführungsform eines erfindungsgemäßen Raddrehzahlsensors;
- Fig. 2: eine Darstellung eines mit dem zweiten Bauteil mit radialem Kabelabgang umgossenen ersten Bauteils des Raddrehzahlsensors;
- Fig. 3: eine Darstellung des Raddrehzahlsensors von Fig. 2 mit montierter Schutzkappe;
- Fig. 4: eine Prinzipskizze einer Draufsicht auf den Raddrehzahlsensor von Fig. 3 zum Erläutern einer Lage einer Achse des Raddrehzahlsensors;
- Fig. 5: eine Prinzipskizze einer Seitenansicht des Raddrehzahlsensors von Fig. 3 zum Erläutern einer Lage einer Achse des Raddrehzahlsensors;
- Fig. 6: eine vergrößerte Darstellung des ersten Bauteils;
- Fig. 7: eine vergrößerte Darstellung eines Querschnitts des ersten Bauteils an einer Stelle eines Schnitts A-A in Fig. 6; und
- Fig. 8: eine vergrößerte Darstellung eines Querschnitts des Raddrehzahlsensors von Fig. 3 an einer Stelle eines Schnitts A-A in Fig. 6.

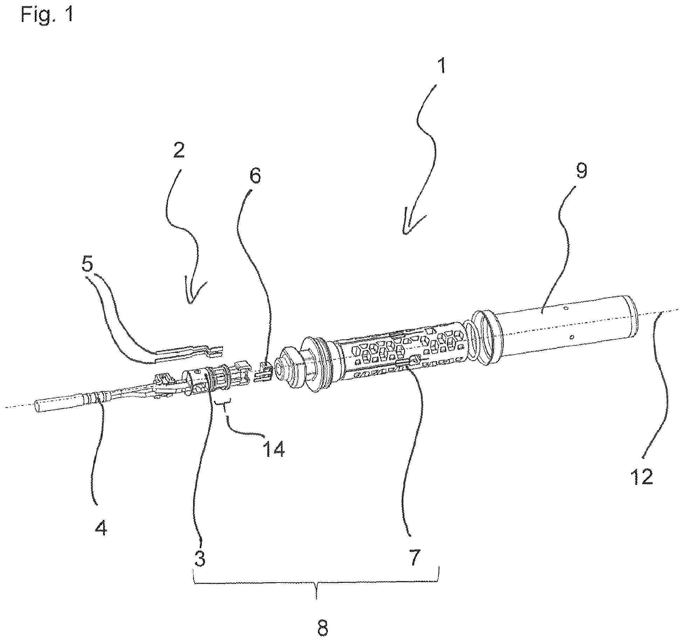

**Fig. 1** zeigt eine Explosionsdarstellung eines erfindungsgemäßen Raddrehzahlsensors 1. Der Raddrehzahlsensor 1 weist eine Vormontagebaugruppe 2 auf.

Die Vormontagebaugruppe 2 weist ein erstes Bauteil 3, ein Kabel 4, Stromschienen 5 und einen aktiven Impulssensor 6, der an dem ersten Bauteil 3 befestigt ist, auf.

Der Impulssensor 6 weist eine vorbestimmte Erfassungsrichtung auf, in der eine Bewegung eines Impulsgebers erfassbar ist. Dies beruht auf dem Effekt, dass ein elektrischer Widerstand des Impulssensors von der Anwesenheit eines Magnetfelds und insbesondere von einer Richtung des Magnetfelds abhängig ist. Der Impulssensor 6 weist einen AMR-Sensor auf. In einer alternativen Ausführungsform ist der Impulssensor 6 mit einem anderen Sensor mit einer vorbestimmten Erfassungsrichtung, beispielsweise einem aktiven Hall-Sensor, versehen.

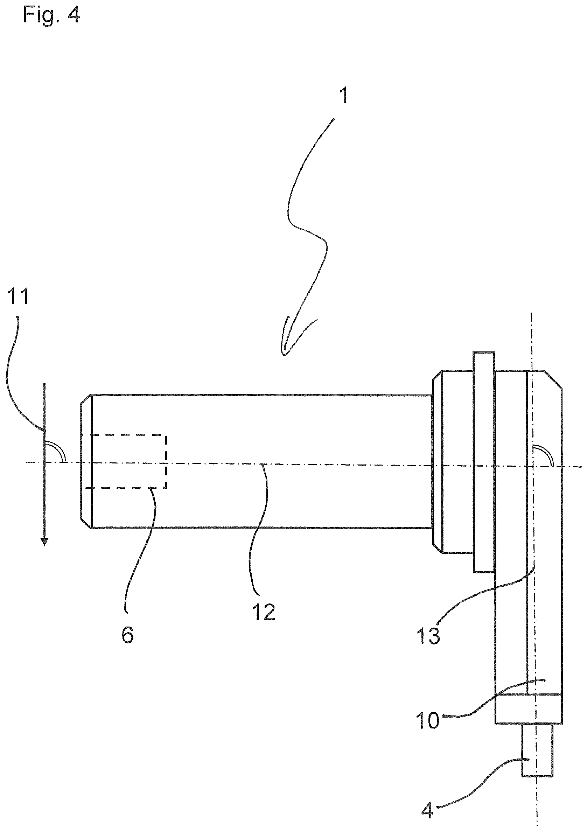

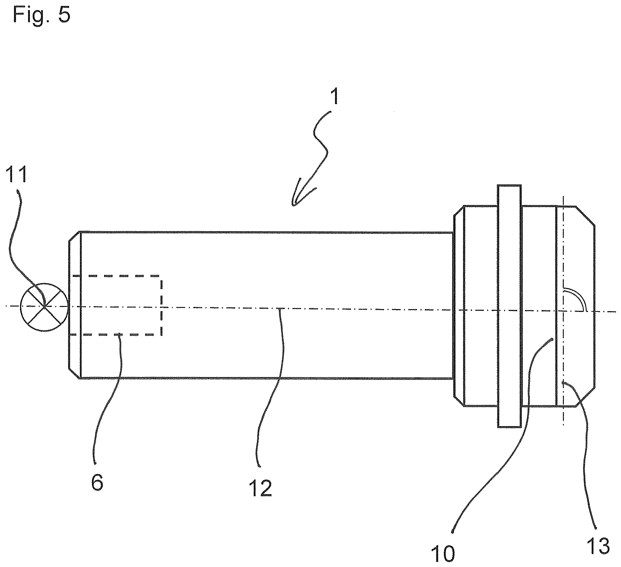

Das erste Bauteil 3 wird durch einen Gießvorgang herstellt, in dem die Stromschienen 5 in das erste Bauteil 3 eingegossen werden, so dass das erste Bauteil 3 als ein Kunststoff-Formteil ausgebildet ist. Das erste Bauteil 3 weist in Richtung einer nachstehend in Verbindung mit Fig. 4 und Fig. 5 definierten Achse 12 einen ersten Bereich 14 auf.

Das Kabel 4 und der Impulssensor 6 werden mit den im ersten Bauteil 3 eingegossenen Stromschienen 5 mechanisch und elektrisch verbunden.

Um das zweite Bauteil 5 um die Vormontagebaugruppe 2 herum herzustellen, wird die Vormontagebaugruppe 2, und somit das erste Bauteil 3, mit einem Kunststoff umgossen. Das zweite Bauteil 7 umschließt den Impulssensor 6 teilweise, umschließt das erste Bauteil 3 vollständig und ist mit dem ersten Bauteil 3 formschlüssig verbunden. Das erste Bauteil 3 und das zweite Bauteil 7 weisen ein gleiches Material auf und bilden ein Gehäuse 8 des Raddrehzahlsensors 1.

In einer alternativen Ausführungsform ist das Gehäuse 8 aus anderen Komponenten aufgebaut, wobei das Gehäuse 8 den Impulssensor 6 vollständig oder teilweise umschließt. In einer weiteren Alternative ist das erste Bauteil 3 nicht vollständig von dem zweiten Bauteil 7 umschlossen oder weist nicht dasselbe Material auf.

Ferner weist der Raddrehzahlsensor 1 eine Schutzkappe 9 auf, die das Gehäuse 8 teilweise abdeckt.

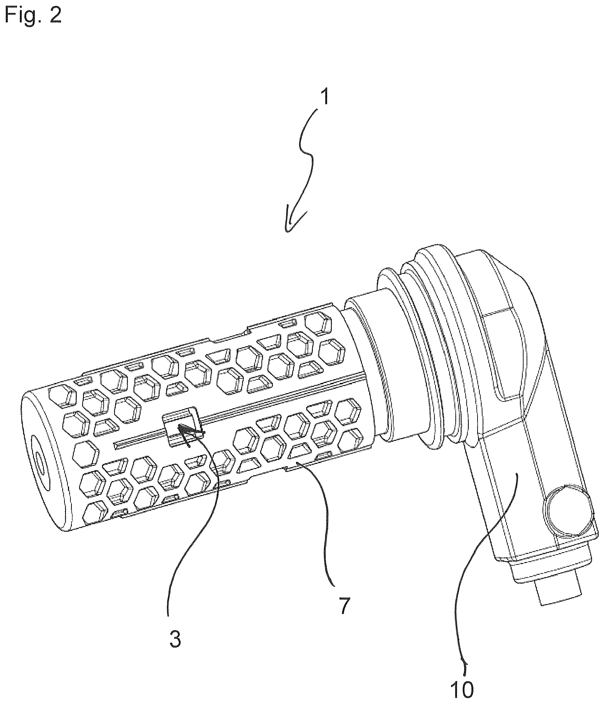

**Fig. 2** zeigt eine Darstellung des mit dem zweiten Bauteil 7 mit radialem Kabelabgang 10 umgossenen ersten Bauteils 3 des Raddrehzahlsensors 1, wobei der Kabelabgang 10 ausgebildet ist, das Kabel 4 aus dem Raddrehzahlsensor 1 herauszuführen.

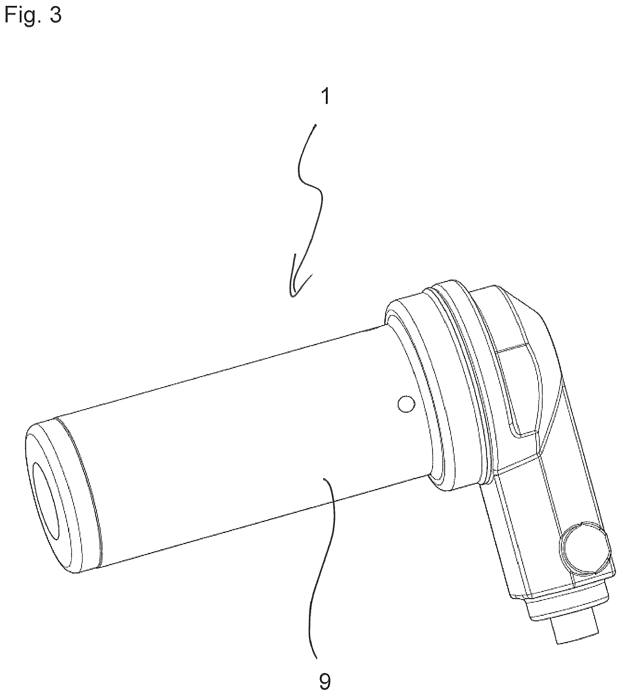

**Fig. 3** zeigt eine Gesamtdarstellung des Raddrehzahlsensors 1 von Fig. 2 mit montierter Schutzkappe 9.

**Fig. 4** zeigt eine Prinzipskizze einer Draufsicht auf den Raddrehzahlsensor von Fig. 3 und **Fig. 5** zeigt eine Prinzipskizze einer Seitenansicht des Raddrehzahlsensors von Fig. 3 zum Erläutern einer Lage einer Achse 12 des Raddrehzahlsensors 1. Der radiale Kabelabgang 10 ist integral mit dem zweiten Bauteil 7 so ausgebildet, dass das Kabel 4 in einer anderen Richtung als in Richtung der Achse 12 herausgeführt wird. In dem gezeigten Ausführungsbeispiel ist der Kabelabgang 10 radial in einem rechten Winkel zur Achse 12 herausgeführt. In einer alternativen Ausführungsform ist das Kabel 4 nicht in einem rechten Winkel herausgeführt.

Eine Richtung der Achse 12 ist so definiert, dass sie senkrecht zu einer Erfassungsrichtung 11 des Impulssensors 6 ausgerichtet ist. Im Falle eines im Wesentlichen achsensymmetrischen länglichen Raddrehzahlsensors 1 entspricht die Achse 12 einer Mittelachse des achsensymmetrischen länglichen Raddrehzahlsensors 1. Eine Ebene 13, die senkrecht zu der Achse 12 angeordnet ist, stellt eine Ebene dar, in der das Kabel 4 in unterschiedlichen vorbestimmten Winkeln aus dem Gehäuse des Raddrehzahlsensors 1 austritt.

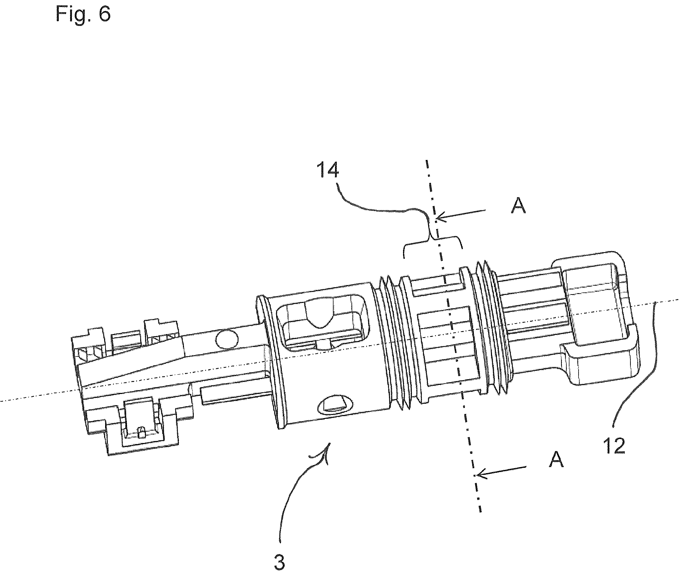

**Fig. 6** zeigt eine vergrößerte Darstellung des ersten Bauteils 3 mit einer Schnittebene, die durch die Pfeile A, A angegeben ist.

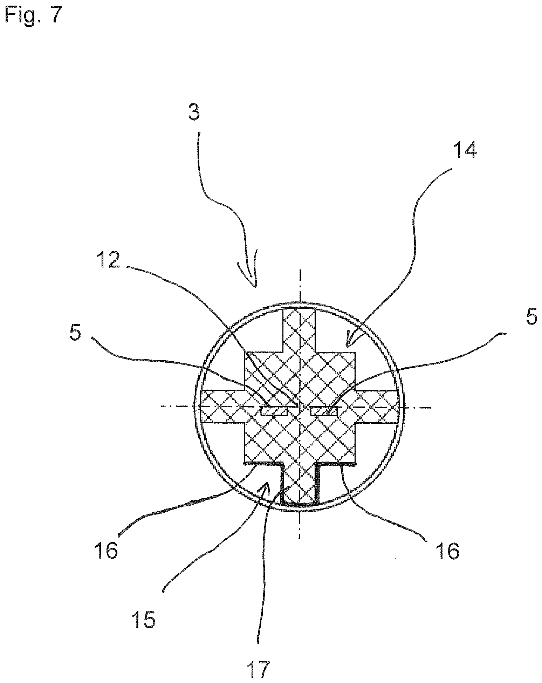

**Fig. 7** zeigt eine vergrößerte Darstellung eines Querschnitts des ersten Bauteils 3 in der in Fig. 6 angegebenen Schnittebene A-A, also in dem ersten Bereich 14. Der erste Bereich 14 hat eine andere als eine rotationssymmetrische Kontur an seinem Umfang.

Der Umfang ist umlaufend stufenförmig und hat ein mit einer dicken Linie dargestelltes Formmerkmal 15. Das Formmerkmal 15 wird aus einer Formmerkmalsebene 16 und einem Formmerkmalssteg 17, der von der Formmerkmalsebene 16 vorsteht, gebildet. Die Kontur weist das Formmerkmal 15 in vorbestimmten Winkelschritten um die Achse 12 auf. Das Formmerkmal 15 ist hier periodisch in vorbestimmten Winkelschritten von 90° vier Mal vorgesehen. Alternativ kann das Formmerkmal 15 auch in 45° Schritten, oder weiterhin alternativ in beliebig großen Winkelschritten, insbesondere in einem Bereich von 80° bis 100° oder einem Bereich von 40° bis 50°, vorgesehen sein.

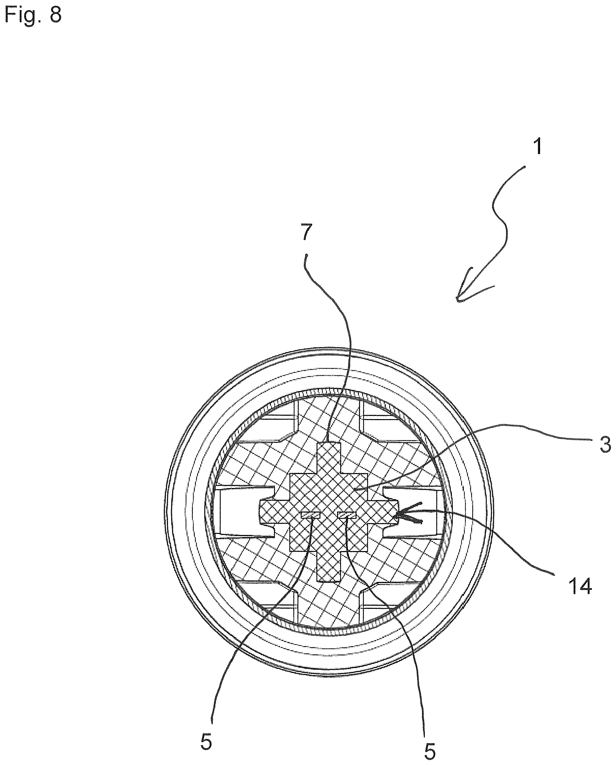

**Fig. 8** zeigt eine vergrößerte Darstellung eines Querschnitts eines Raddrehzahlsensors 1 von Fig. 3 an der Stelle der Schnittebene A-A in Fig. 6.

In Fig. 8 ist ein Querschnitt des ersten Bereichs 14 des ersten Bauteils 3 und ein Querschnitt eines zweiten Bereichs des zweiten Bauteils 7, dessen innere Kontur komplementär zu der Kontur am Umfang des ersten Bereichs 14 des ersten Bauteils 3 ausgebildet ist, gezeigt. In alternativen Ausführungsformen stimmen die Konturen teilweise komplementär überein, wobei das Formmerkmal 15 mit einem komplementären Teil der Kontur des zweiten Bereichs des zweiten Bauteils 7 übereinstimmt. Dadurch ist beim Zusammenbau eine Orientierung des ersten Bauteils 3 zu dem zweiten Bauteil 7 in den vorbestimmten Winkelschritten um die Achse 12 variabel definierbar, um einen vorbestimmten Winkel um die Achse 12 zwischen der Erfassungsrichtung 11 des Impulssensors 6 und dem radialen Kabelabgang 10 bereitzustellen.

Der vorbestimmte Winkel wird, wie nachstehend erläutert, bei einer Herstellung des Gehäuses 8 durch Umgießen, durch eine Orientierung der Vormontagebaugruppe 2 in einem Gießwerkzeug bereitgestellt. Bei einem alternativen Herstellungsverfahren, in dem beispielsweise das zweite Bauteil 7 aus zwei Teilen besteht, die durch Zusammenklipsen das zweite Bauteil 7 bilden, das dann das erste Bauteil 3 umschließt, kann ein entsprechendes Gegenformmerkmal des zweiten Bauteils zu dem Formmerkmal 15 in dem zweiten Bauteil 7 so vorgesehen sein, dass der vorbestimmte Winkel durch ein Einbringen des Formmerkmals 15 in das Gegenformmerkmal des zweiten Bauteils 7 bereitgestellt wird.

Ferner sind die Stromschienen 5 in Fig. 7 und Fig. 8 in einem in dem ersten Bauteil 3 eingegossenen Zustand dargestellt. In alternativen Ausführungsformen sind die Stromschienen nicht in dem ersten Bauteil 3 eingegossen sondern in einer anderen Weise an dem ersten Bauteil 3 befestigt. Weiterhin sind alternativ die Stromschienen nicht zwingend erforderlich, sofern das Kabel 4 direkt mit dem Impulssensor 6 verbunden ist.

Eine Herstellung des Raddrehzahlsensors 1 wird nachstehend erläutert.

Zunächst wird die Vormontagebaugruppe 2 hergestellt. Dazu werden die Stromschienen 5 in ein erste-Baugruppe-Gießwerkzeug eingelegt und dann so umgossen, dass das erste Bauteil 3 mit den darin eingegossenen Stromschienen 5 gebildet wird (siehe auch Figuren 7 und 8).

Anschließend werden das Kabel 4 und der Impulssensor 6 mit den Stromschienen 5 verbunden. Dies erfolgt über Schweißen, oder alternativ über Löten oder ein anderes geeignetes Verbindungsverfahren, wie beispielsweise Crimpen. Die Vormontagebaugruppe ist in diesem Zustand geeignet, sowohl für den Raddrehzahlsensor 1 mit dem radialen Kabelabgang 10 als auch für den Raddrehzahlsensor 1 mit einem axialen Kabelabgang verwendet zu werden.

In einem alternativen Verfahren wird die Vormontagebaugruppe 2, beispielsweise ohne die Stromschienen 5, in einer anderen Weise hergestellt.

Anschließend wird die Vormontagebaugruppe 2, die das erste Bauteil 3, den Impulssensor 6 und das Kabel 4 aufweist, in einem zweites-Bauteil-Gießwerkzeug zur Herstellung des zweiten Bauteils 3 einschließlich des radialen Kabelabgangs 10 bereitgestellt, indem es in das zweites-Bauteil-Gießwerkzeug eingelegt wird. Dabei wird das erste Bauteil 3 zu dem zweites-Bauteil-Gießwerkzeug durch Einbringen von einem der Formmerkmale 15 in ein entsprechendes Gegenformmerkmal des zweites-Bauteil-Gießwerkzeugs so orientiert, dass der gewünschte vorbestimmte Winkel zwischen dem Impulssensor 6 und dem radialen Kabelabgang 10 um die Achse 12 festgelegt wird. In der gezeigten Ausführungsform wird der Formmerkmalssteg 17 (Fig. 7) in eine entsprechende Vertiefung in dem zweites-Bauteil-Gießwerkzeug eingebracht.

Durch diese Ausrichtung wird die Orientierung des Impulssensors 6 in dem zweites-Bauteil-Gießwerkzeug festgelegt. In der gezeigten Ausführungsform ist eine die Orientierung des Impulssensors 6 in einem 90°-Raster möglich. Da das zweites-Bauteil-Gießwerkzeug einen Formabschnitt für den radialen Kabelabgang 10 an einer festen Position aufweist, wird somit der vorbestimmte Winkel zwischen dem Impulssensor 6 und dem radialen Kabelabgang 10 um die Achse 12 ermöglicht.

Das Kabel 4 wird anschließend in eine Aufnahme des zweites-Bauteil-Gießwerkzeugs eingelegt, so dass das Kabel 4 in einer geeigneten Lage bereitgestellt wird, um von Gießmaterial umgießbar zu sein, wobei dann der radiale Kabelabgang 10 gebildet wird. Anschließend wird das Gießmaterial in das zweites-Bauteil-Gießwerkzeug eingefüllt, das erste Bauteil 3 mit dem Impulssensor 6 dadurch umgossen, und die zweite Baugruppe 7 mit dem daran integral hergestellten radialen Kabelabgang 10 wird dadurch hergestellt.

### BEZUGSZEICHENLISTE

- 1: Raddrehzahlsensor
- 2: Vormontagebaugruppe
- 3: erstes Bauteil
- 4: Kabel
- 5: Stromschiene
- 6: Impulssensor
- 7: zweites Bauteil
- 8: Gehäuse
- 9: Schutzkappe
- 10: radialer Kabelabgang
- 11: Erfassungsrichtung
- 12: Achse
- 13: Ebene
- 14: erster Bereich
- 15: Formmerkmal
- 16: Formmerkmalsebene
- 17: Formmerkmalssteg

## Patentansprüche

1. Raddrehzahlsensor (1) für ein Nutzfahrzeug, aufweisend
einen Impulssensor (6) mit einer vorbestimmten Erfassungsrichtung, und
ein Gehäuse (8), das ausgebildet ist, den Impulssensor (6) zumindest teilweise zu umschließen,
wobei
durch den Impulssensor (6) eine Bewegung eines Impulsgebers in der vorbestimmten Erfassungsrichtung (11), erfassbar ist,
der Raddrehzahlsensor (1) eine Achse (12) aufweist, wobei eine Richtung der Achse (12) so definiert ist, dass sie senkrecht zu der Erfassungsrichtung (11) des Impulssensors (6) ausgerichtet ist,
das Gehäuse (8) ein erstes Bauteil (3) und ein zweites Bauteil (7), von dem das erste Bauteil (3) zumindest teilweise umschließbar ist und mit dem das erste Bauteil (3) zumindest teilweise formschlüssig verbindbar ist, aufweist,
der Impulssensor (6) an dem ersten Bauteil (3) befestigt ist,
der Raddrehzahlsensor (1) einen radialen Kabelabgang (10) aufweist, der radial zu der Achse (12) ausgerichtet ist, und der ausgebildet ist, ein Kabel (4) aus dem Raddrehzahlsensor (1) herauszuführen,
der radiale Kabelabgang (10) integral mit dem zweiten Bauteil (7) so ausgebildet ist, dass das Kabel (4) in einer anderen Richtung als in Richtung der Achse (12) geführt wird,
das erste Bauteil (3) in der Richtung der Achse (12) einen ersten Bereich (14) aufweist, der eine andere als eine rotationssymmetrische Kontur an seinem Umfang hat, und das zweite Bauteil (7) einen zweiten Bereich aufweist, dessen innere Kontur zumindest teilweise komplementär zu der Kontur am Umfang des ersten Bereichs (14) ausgebildet ist, und
die Kontur am Umfang des ersten Bereichs (14) jeweils ein Formmerkmal (15) in vorbestimmten Winkelschritten um die Achse (12) aufweist, so dass das erste Bauteil (3) so ausgebildet ist, dass eine Orientierung des ersten Bauteils (3) zu dem zweiten Bauteil (7) in den vorbestimmten Winkelschritten um die Achse (12) definierbar ist, um einen vorbestimmten Winkel um die Achse (12) zwischen der Erfassungsrichtung (11) des Impulssensors (6) und dem radialen Kabelabgang (10) bereitzustellen,
**dadurch gekennzeichnet, dass**
der Impulssensor (6) ein aktiver Impulssensor ist,
das erste Bauteil (3) als ein Kunststoff-Formteil ausgebildet ist, und das zweite Bauteil (7) durch Umgießen des ersten Bauteils (3) mit einem Kunststoff ausgebildet ist.

2. Raddrehzahlsensor (1) gemäß Anspruch 1, wobei
der Impulssensor (6) einen AMR-Sensor aufweist.

3. Raddrehzahlsensor (1) gemäß einem der Ansprüche 1 oder 2, wobei
das erste Bauteil (3) und das zweite Bauteil (7) ein gleiches Material aufweisen.

4. Raddrehzahlsensor (1) gemäß einem der vorangehenden Ansprüche, wobei
die vorbestimmten Winkelschritte in einem Bereich von 80°bis 100° liegen.

5. Raddrehzahlsensor (1) gemäß einem der vorangehenden Ansprüche 1 bis 4, wobei
die vorbestimmten Winkelschritte in einem Bereich von 40° bis 50° liegen.

6. Verfahren zum Herstellen eines Raddrehzahlsensors (1) gemäß einem der vorangehenden Ansprüche mit den Schritten:
Bereitstellen einer Vormontagebaugruppe (2), die das erste Bauteil (3), den Impulssensor (6), und das Kabel (4) vormontiert aufweist, in einem zweites-Bauteil-Gießwerkzeug zur Herstellung des zweiten Bauteils (7) einschließlich des radialen Kabelabgangs (10);
Orientieren des ersten Bauteils (3) in dem zweites-Bauteil-Gießwerkzeug durch Einbringen von einem der Formmerkmale (15) in ein entsprechendes Gegenformmerkmal des zweites-Bauteil-Gießwerkzeugs so, dass ein gewünschter vorbestimmter Winkel zwischen dem Impulssensor (6) und dem radialen Kabelabgang (10) um die Achse (12) festgelegt wird;
Umgießen des ersten Bauteils (3) und des Kabels (4), so dass das zweite Bauteil (7) mit dem radialen Kabelabgang (10) um das erste Bauteil (3) herum hergestellt wird.

7. Verfahren gemäß Anspruch 6 mit den zusätzlichen Schritten zur Herstellung der Vormontagebaugruppe (2):
Umgießen von Stromschienen (5) in einem erste-Baugruppe-Gießwerkzeug zum Herstellen des ersten Bauteils;
Verbinden des Kabels (4) mit den Stromschienen (5);
Verbinden des Impulssensors (6) mit den Stromschienen (5).

## Claims

1. A wheel speed sensor (1) for a utility vehicle, having
a pulse sensor (6) having a predetermined direction of detection, and
a housing (8) that is configured to at least partially enclose the pulse sensor (6),
it being possible to detect a movement of a pulse generator in the predetermined direction of detection (11) by means of the pulse sensor (6),
the wheel speed sensor (1) having an axis (12), a direction of the axis (12) being defined so as to be aligned perpendicular to the direction of detection (11) of the pulse sensor (6),
the housing (8) having a first component (3) and a second component (7) that are able to at least partially enclose the first component (3) and to which the first component (3) can be at least partially connected in a form fit,
the pulse sensor (6) being fastened to the first component (3),
the wheel speed sensor (1) having a radial cable outlet (10) that is aligned radially to the axis (12) and is configured to lead a cable (4) out of the wheel speed sensor (1),
the radial cable outlet (10) being formed integrally with the second component (7) such that the cable (4) is led in a direction other than the direction of the axis (12),
the first component (3) having a first region (14) in the direction of the axis (12), this region (14) having on its circumference a contour other than a rotationally-symmetrical contour, and the second component (7) having a second region with an inner contour that is configured so as to be at least partially complementary to the contour on the circumference of the first region (14), and
the contour on the circumference of the first region (14) having a form characteristic (15) in predetermined angular steps around the axis (12) such that the first component (3) is configured in such a way that it is possible to define an orientation of the first component (3) in relation to the second component (7) in the predetermined angular steps about the axis (12) in order to provide a predetermined angle about the axis (12) between the direction of detection (11) of the pulse sensor (6) and the radial cable outlet (10),
**characterised in that**,
the pulse sensor (6) is an active pulse sensor,
the first component (3) takes the form of a moulded plastic part, and the second component (7) is formed by extrusion coating the first component (3) with a plastic.

2. A wheel speed sensor (1) according to claim 1,
the pulse sensor (6) being an AMR sensor.

3. A wheel speed sensor (1) according to either of claims 1 or 2,
the first component (3) and the second component (7) being of the same material.

4. A wheel speed sensor (1) according to any one of the preceding claims,
the predetermined angular steps lying within a range of 70° to 100°.

5. A wheel speed sensor (1) according to any one of claims 1 to 4,
the predetermined angular steps lying within a range of 40° to 50°.

6. A method for the production of a wheel speed sensor (1) according to any one of the preceding claims, having the following steps:
the provision of a subassembly component (2), in which the first component (3), the pulse sensor (6) and the cable (4) are preassembled, in a second-component moulding die for producing the second component (7) including the radial cable outlet (10);
the orientation of the first component (3) in the second-component moulding die by introducing one of the form characteristics (15) into a corresponding counter-form characteristic of the second-component moulding die such that a desired predetermined angle about the axis (12) is defined between the pulse sensor (6) and the radial cable outlet (10);
the extrusion coating of the first component (3) and the cable (4) such that the second component (7) with the radial cable outlet (10) is produced around the first component (3).

7. A method according to claim 6 having the following additional steps for producing the subassembly component (2):
the extrusion coating of busbars (5) in a first-component moulding die for producing the first component;
the connection of the cable (4) to the busbars (5);
the connection of the pulse sensor (6) to the busbars (5).

## Revendications

1. Capteur (1) de vitesse de rotation de roue pour un véhicule utilitaire comportant
un capteur (6) d'impulsions ayant une direction de détection déterminée à l'avance, et
une enveloppe (8), qui est constituée pour entourer au moins en partie le capteur (6) d'impulsions,
dans lequel
par le capteur (6) d'impulsions, un déplacement d'un émetteur d'impulsions peut être détecté dans le dispositif (11) de détection déterminé à l'avance,
le capteur (1) de vitesse de rotation de roue a un axe (12), dans lequel une direction de l'axe (12) est définie, de manière à être dirigée perpendiculairement à la direction (11) de détection du capteur (6) d'impulsions,
l'enveloppe (8) a une première pièce (3) et une deuxième pièce (7), qui peut être entourée au moins en partie par la première pièce (3) et qui peut être reliée à complémentarité de forme au moins en partie à la première pièce (3),
le capteur (6) d'impulsions est fixé à la première pièce (3),
le capteur (1) de vitesse de rotation de roue a une sortie (10) radiale de câble, qui est dirigée radialement par rapport à l'axe (12) et qui est constituée pour faire sortir un câble (4) du capteur (1) de vitesse de rotation de roue,
la sortie (10) radiale de câble est constituée d'un seul tenant avec la deuxième pièce (7), de manière à guider le câble (4) dans une direction autre que la direction de l'axe (12),
la première pièce (3) a, dans la direction de l'axe (12), une autre partie (14), qui a un contour autre que de révolution sur son pourtour, et la deuxième pièce (7) a une deuxième partie, dont le contour intérieur est complémentaire au moins en partie du contour du pourtour de la première partie (14), et
le contour du pourtour de la première partie (14) a respectivement une caractéristique (15) de forme en des pas angulaires déterminés à l'avance autour de l'axe (12), de manière à ce que la première pièce (3) soit constituée de façon à pouvoir définir une orientation de la première pièce (3) par rapport à la deuxième pièce (7) en les pas angulaires déterminés à l'avance autour de l'axe (12), afin de disposer d'un angle déterminé à l'avance autour de l'axe (12) entre la direction (11) de détection du capteur (6) d'impulsions et la sortie (10) radiale de câble,
**caractérisé en ce que**
le capteur (6) d'impulsions est un capteur d'impulsions actif,
la première pièce (3) est une pièce moulée en matière plastique et la deuxième pièce (7) est formée en coulant une matière plastique autour de la première pièce (3).

2. Capteur (1) de vitesse de rotation de roue suivant la revendication 1, dans lequel
le capteur (6) d'impulsions a un capteur AMR.

3. Capteur (1) de vitesse de rotation de roue suivant la revendication 1 ou 2, dans lequel
la première pièce (3) et la deuxième pièce (7) ont le même matériau.

4. Capteur (1) de vitesse de rotation de roue suivant l'une des revendications précédentes, dans lequel
les pas angulaires déterminés à l'avance sont dans une plage de 80° à 100°.

5. Capteur (1) de vitesse de rotation de roue suivant l'une des revendications 1 à 4 précédentes, dans lequel
les pas angulaires déterminés à l'avance sont dans une plage de 40° à 50°.

6. Procédé de fabrication d'un capteur (1) de vitesse de roue suivant l'une des revendications précédentes, comprenant les stades :
on se procure un module (2) de prémontage, qui a prémonté la première pièce (3), le capteur (6) d'impulsions et le câble (4), dans un outil de coulée de deuxième pièce pour la fabrication de la deuxième pièce (7), y compris la sortie (10) radiale de câble,
on oriente la première pièce (3) dans l'outil de coulée de la deuxième pièce en mettant l'une des caractéristiques (15) de forme dans une caractéristique de contreforme correspondante de l'outil de coulée de la deuxième pièce, de manière à fixer un angle souhaité déterminé à l'avance entre le capteur (6) d'impulsions et la sortie (10) radiale de câble autour de l'axe (12),
on effectue une coulée autour de la première pièce (3) et du câble (4), de manière à fabriquer la deuxième pièce (7) ayant la sortie (10) radiale de câble tout autour de la première pièce (3) .

7. Procédé suivant la revendication 6, ayant les stades supplémentaires de fabrication du module (2) de prémontage :
coulée autour de barres (5) de courant, dans un outil de coulée de premier module, pour fabriquer la première pièce ;
liaison du câble (4) aux barres (5) de courant ;
liaison du capteur (6) d'impulsions aux barres (5) de courant.
